# EUROPEAN PATENT SPECIFICATION

(11) **EP 0 542 271 B1**
(45) Date of publication and mention of the grant of the patent: **14.01.1998**
(21) Application number: 92119377.7
(22) Date of filing: 12.11.1992
(51) Int. Cl.: H01L 29/772, H01L 29/43, G02F 1/136, H01L 23/485

(54) **Thin-film device with a compound conductive layer**
Dünnfilmanordnung mit einer leitenden Verbindungsschicht
Dispositif à couche mince avec une couche conductrice composée

(30) Priority: 15.11.1991 JP 326773/91; 15.11.1991 JP 326774/91; 15.11.1991 JP 326775/91; 15.11.1991 JP 326777/91; 24.12.1991 JP 355633/91
(43) Date of publication of application: 19.05.1993
(73) Proprietor: CASIO COMPUTER COMPANY LIMITED, Shinjuku-ku Tokyo 160 (JP)
(72) Inventor: Ohno, Ichiro, Hachioji-shi, Tokyo (JP); Shiota, Junji, Tachikawa-shi, Tokyo (JP)
(74) Representative: Grünecker, Kinkeldey, Stockmair & Schwanhäusser Anwaltssozietät

(56) References cited:
- US-A- 5 018 001
- PATENT ABSTRACTS OF JAPAN, vol. 11, no. 3 (C-395) 7 January 1987; & JP-A-61 183 433
- PATENT ABSTRACTS OF JAPAN, vol. 15, no. 323 (E-1101) 16 August 1991; & JP-A-03 120 722
- PATENT ABSTRACTS OF JAPAN, vol. 12, no. 110 (C-486) 8 April 1988; & JP-A-62 235 454
- PATENT ABSTRACTS OF JAPAN, vol. 13, no. 312 (E-788) 17 July 1989; & JP-A-01 084 639

## Description

The present invention relates to a thin-film device.

In particular, the present invention relates to a first thin film device a thin-film device comprising an insulating substrate, a first conductive layer located above the insulating substrate, an insulating film covering the first conductive layer; and a second conductive layer formed on the insulating film and electrically insulated from the first conductive layer, wherein said first conductive layer located close to said insulating substrate is made of aluminium alloy containing high-melting metal.

The present invention also relates to a second thin film device a thin-film device comprising: an insulating substrate; a plurality of transparent pixel electrodes arranged in rows and columns on said insulating substrate; a plurality of thin-film transistors located at said pixel electrodes, respectively, each having a gate electrode, a gate insulating film formed on the gate electrode, an i-type semiconductor layer formed on the gate insulating film, and a source electrode and a drain electrode electrically connected to two ends of the i-type semiconductor layer, respectively, and each having one of the source and drain electrodes connected to the associated pixel electrodes; a plurality of scan lines extending parallel to one another, each connecting the gate electrodes of the thin film transistors of the same row; and a plurality of data lines extending parallel to one another, each connecting the source electrodes or drain electrodes of the thin-film transistors of the same column, which are other than those connected to the pixel electrodes, wherein at least one of said gate electrode, said source electrode, said drain electrode, said scan lines, and said data lines is constructed by a conductive layer made of aluminium alloy containing high-melting metal.

Such thin film devices are known from JP-A-61 183 433 (see also patent abstracts of Japan, Volume 11, Page 3).

The thin-film device is used as multi-layer wiring substrates, thin-film diodes and thin-film transistors.

In most cases, the upper and lower conductive layers (wirings) of the thin-film device are made of metal such as chromium (Cr), tantalum (Ta), molybdenum (Mo), or the like, and the thin insulating film of the device is made of silicon nitride (SiN) or the like. When the thin-film device is manufactured in the form of a thin-film transistor, it has a semiconductor layer of amorphous silicon (a-Si).

A conventional multi-layer wiring board having layers made of high-melting metal such as Cr, Ta, Mo or the like has two problems. First, its manufacturing cost is high since Cr, Ta, Mo or the like is expensive. Second, since the high melting metal layers have high resistance, the voltage drop in the metal layers is so great as to deteriorate the operating characteristics of semiconductor elements or the like connected to the metal layers.

To solve these problems, it has been proposed that the conductive layer of a multi-layer wiring board be made of aluminum (Aℓ) since aluminum is inexpensive and has a low electrical resistivity. If the conductive layer is made of aluminum, the following problem will arise.

A multi-layer wiring board is manufactured in the following steps. First, a lower conductive layer is formed on an insulating substrate (e.g., a glass substrate). Then, an insulating film is formed on the lower conductive layer. Next, an upper conductive layer is finally formed on the insulating film. The insulating film is formed by a plasma CVD apparatus at a film-forming temperature of hundreds of degrees centigrade. If the lower conductive layer is made of aluminum, it will have hillocks on its surface during the forming of the insulating film. The hillocks protrude into the insulating film, forming defects, e.g., cracks, in the insulating film. Due to the defects, the lower conductive layer will be short-circuited to the upper conductive layer.

Assume the thin-film device described above is used as a thin-film transistor of reverse stagger type. The thin-film transistor is manufactured in the following way. First, a gate electrode (i.e., a lower electrode) is formed on an insulating substrate (e.g., a glass substrate). Next, a gate insulating film is formed on the substrate and the gate electrode. Then, a semiconductor layer is formed on the gate insulating film. Further, a source electrode and a drain electrode (i.e., upper electrodes) are formed on the semiconductor layer. The gate insulating film and the semiconductor layer are formed by a plasma CVD apparatus at a film-forming temperature of hundreds of degrees centigrade. Hence, if the gate electrode is made of aluminum, it will have hillocks on its surface during the forming of the gate insulating film and/or the semiconductor layer. The hillocks protrude into the gate insulating film, forming defects in the gate insulating film. Due to the defects, the gate electrode will be short-circuited to the source and drain electrodes.

In other types of thin-film devices such as a stagger type thin-film transistor, a coplanar type thin-film transistor, a reverse coplanar type thin-film transistor and a thin-film diode, the lower conductive layer, if made of aluminum, will also have hillocks on its surface during the forming of an insulating film, forming defects in the insulating film.

It has been pointed out that an aluminum layer will not have hillocks even if heated to hundreds of degrees centigrade, provided that it contains a small amount of high-melting metal (e.g., Ti or Ta). Thus, if the lower conductive layer of a thin-film device is made of aluminum containing a high-melting metal, it will have no hillocks on its surface during the forming of an insulating film.

The inventors hereof made a multi-layer wiring board having a lower conductive layer of aluminum containing a high-melting metal. The lower conductive layer and upper conductive layer of this board were short-circuited to each other. To determine why so, the inventors conducted the following experiment.

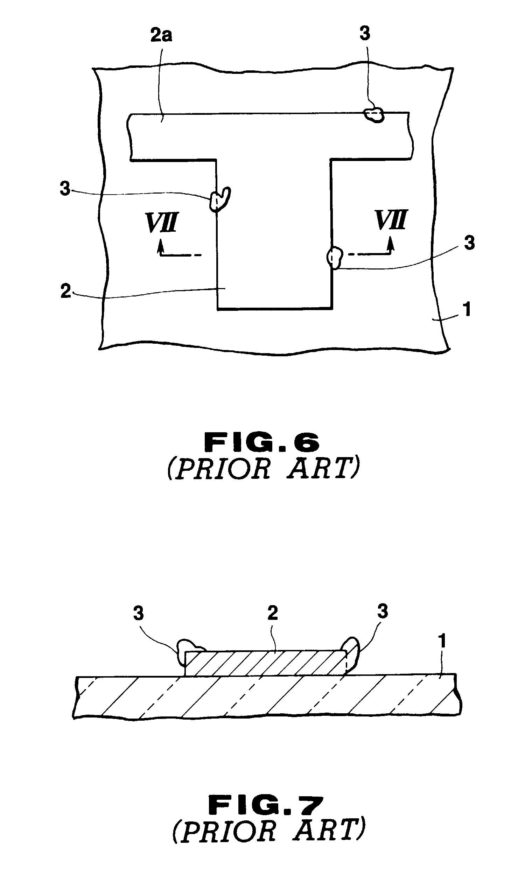

First, they formed a conductive layer 2 made of Ti-containing aluminum, on a glass substrate 1, as is shown in Figs. 6 and 7. Next, they heated the glass substrate 1 to about 250°C and examined the surface condition of the conductive layer 2. No hillocks were formed on the surface of the layer 2, but projections 3 were formed, extending from the sides and edges of the conductive layer 2. The projections 3 were formed, probably because crystal grew locally in the sides and edges of the layer 2 during the layer 2 was heated gradually.

A multi-layer wiring board is manufactured by the method described above. When an insulating film is formed on the lower conductive layer, the lower conductive layer is inevitably heated to the temperature at which the insulating film is formed. Hence, projection will be formed, extending from the sides and edges of the lower conductive layer, during the forming of the insulating film, even if the lower conductive layer is made of aluminum containing a high-melting metal. The projections protrude into the insulating film, forming detects, such as cracks, in the insulating film. Due to these defects, the lower conductive layer is short-circuited to the upper conductive layer which is subsequently formed on the insulating film.

The object of this invention is to provide a thin-film device which comprises a lower conductive layer made of aluminum, an insulating film formed on the lower conductive layer, and an upper conductive layer formed on the insulating film, and in which the lower conducive layer has neither hillocks nor projections, though it is made of aluminum, i.e., an inexpensive, low-melting metal has been heated to high temperature during the forming of the insulating film, and no defects are formed in the insulating film, thus preventing short-circuiting between the the lower and upper conductive layers. the above-mentioned first thin-film device is characterised in that said first conductive layer contains 2.2 wt% or more of high-melting metal and 4 at% or more of oxygen or nitrogen, or both.

The above object is also achieved with the above-mentioned second thin-film device being characterised in that said conductive layer contains 2.2 wt% or more of high-melting metal and 4 at% or more of oxygen or nitrogen or both.

The oxygen and/or nitrogen, contained in said amount in the aluminum alloy, inhibit abnormal growth of aluminum crystal, and no projections protrude from the edges of the conductive layer.

It is desirable that oxygen and/or nitrogen be contained in the aluminum alloy in an amount small enough not to noticeably increase the electrical conductivity of the aluminum alloy. Preferably, the high-melting metal contains titanium or tantalum, or both. The content of titanium and/or tantalum is selected in accordance with the temperature at which to heat-treat the thin-film device. It is preferably about 2.2 wt% (weight percent) or more if the heat treatment temperature is 250°C. The higher the temperature, the higher the content of titanium and/or tantalum.

The most desirable for the material of the conductive layer is an aluminum alloy which contains titanium used as high-melting metal and about 4 at% or more of oxygen, preferably not exceeding 10 at%.

The present invention can be used applied to a thin-film transistor. In this case, of the gate electrode, the source electrode and the drain electrode, at least the electrode (i.e., conductive layer) which is located near the insulating substrate is made of the aluminum alloy specified above. No projections protrude from the edges of the electrode located near the substrate even if the electrode is exposed in an atmosphere of a relative high temperature. Hence, the gate electrode and the source electrode are not short-circuited to each other, nor are the gate electrode and the drain electrode short-circuited to each other.

The present invention can also applied to a thin-film transistor panel comprising a insulating substrate and thin-film transistors arranged in rows and columns on the insulating substrate. In this case, of the scan lines each connecting the gate electrodes of the transistors of the same row and the data lines each connecting the drain electrodes of the transistors of the same column, at least those located near the insulating substrate are made of the aluminum alloy specified above. Since the aluminum alloy contains a high-melting metal and oxygen and/or nitrogen, no projections protrude from the edges of each scan line and/or each data line. Hence, no short-circuiting occur between any scan line and any data line. The gate electrodes of the thin-film transistors of each row may be formed integral with the associated scan line, and the drain electrodes of the thin-film transistors of each column may be formed integral with the associated data line.

This invention can be more fully understood from the following detailed description when taken in conjunction with the accompanying drawings, in which:
Fig. 1 is a cross-sectional view of a thin-film device according to one embodiment of the invention, taken along line I-I in Fig. 3;
Fig. 2 is a cross-sectional view of the thin-film transistor according to the invention, taken along line II-II in Fig. 3;
Fig. 3 is a plan view of part of a thin-film transistor panel comprising a plurality of thin-film transistors identical to the one shown in Figs. 1 and 2;
Fig. 4 is a cross-sectional view of a thin-film transistor of another type according to the invention;
Fig. 5 is a schematic view of an apparatus for forming a conductive layer according to the present invention;
Fig. 6 is a plan view of a conductive layer which has been heat-treated by the conventional method; and
Fig. 7 is a cross-sectional view of the conductive layer, taken along line VII-VII in Fig. 6.

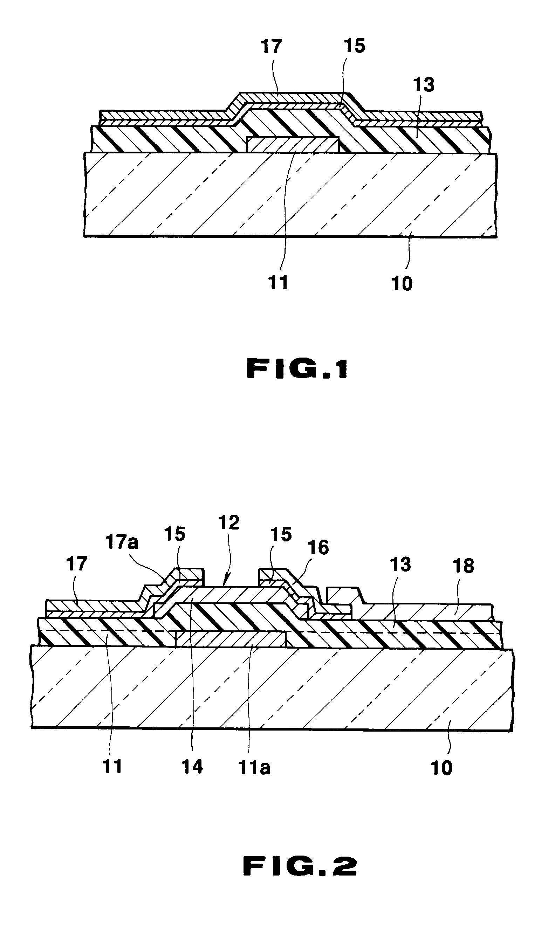

An embodiment of the invention will be described, with reference to Figs. 1 to 5. This embodiment is a thin-film device for use in a TFT active matrix liquid-crystal display.

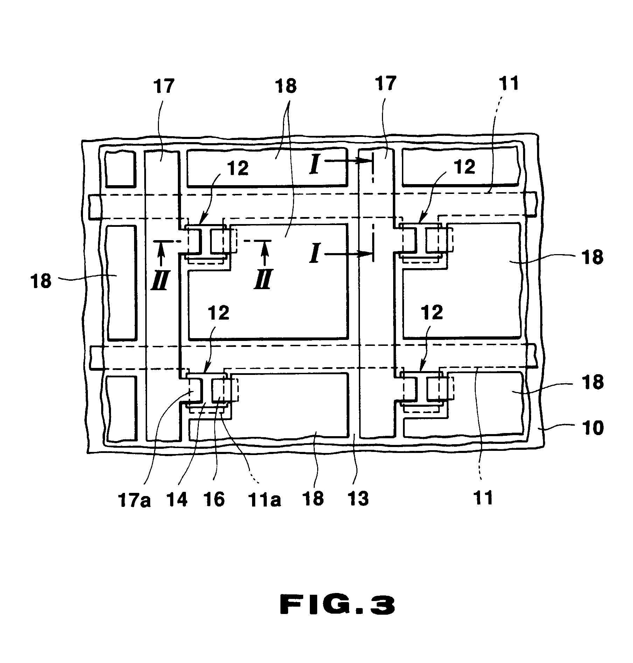

The TFT active matrix liquid-crystal display has a thin-film transistor (TFT) panel which is a multi-layer wiring board. As is shown in Fig. 3, the TFT panel comprises a transparent insulating substrate 10 made of glass or the like, a plurality of scan lines 11 formed on the substrate 10 and extending parallel to one another, a plurality of data lines 17 extending at right angles to the scan lines 11, a plurality of, for example, thin-film transistors (TFTs) 12 (i.e., active elements), and a plurality of pixel electrodes 18 connected to the thin-film transistors 12. The transistors 12 are of reverse stagger type, formed on the substrate 10 and located at the intersections of the scan lines 11 and the data lines 17, respectively.

As is shown in Fig. 2, each of the reverse stagger type thin-film transistors 12 comprises a gate electrode 11a, a gate insulating film 13 made of SiN and formed on the gate electrode 11a, an i-type semiconductor layer 14 made of a-Si (amorphous silicon), formed on the film 13 and located above the a gate electrode 11a, an n-type semiconductor layer 15 made of a-Si doped with n-type impurity and formed on the i-type semiconductor layer 14, and a source electrode 16 and a drain electrode 17a, both formed on the n-type semiconductor layer 15 and located above the opposing end portions of the i-type semiconductor layer 14.

The gate electrode 11a of the thin-film transistor 12 is formed on the substrate 10 and integral with one of the scan lines 11 which are formed on the substrate 10, too. The gate insulating film 13 covers almost the entire surface of the substrate 10 and, therefore, covers the scan lines 11. The end portions of each scan line 11 are exposed through openings made in the gate insulating film 13. The drain electrode 17a of the thin-film transistor 12 is integral with one of the data lines 17 which are formed on the gate insulating film 13.

As can be best seen from Fig. 2, the scan lines 11 are the lower layers of the TFT panel (i.e., a multi-layer wiring board), and the data lines 17 are the upper layers of the TFT panel. The scan lines 11 are electrically insulated from the data lines 17 by the gate insulating film 13.

The pixel electrode 18 is made of transparent conductive material such as ITO. As is shown in Fig. 2, the electrode 18 is formed on the gate insulating film 13. It has its one end located on the source electrode 16 of the thin-film transistor 12 and is, thus, connected to the source electrode 16.

The TFT panel is manufactured in the following method.

First, a lower metal layer is formed on the substrate 10 by means of a sputtering apparatus. The metal layer is patterned, forming the scan lines 11 and gate electrodes 11a. Next, the gate insulating film 13 is formed on the substrate 10, the scan lines 11, and the gate electrodes 11a, by means of a plasma CVD apparatus. The i-type semiconductor layer 14 is formed on the gate insulating film 13, also by the plasma CVD apparatus. Then, the n-type semiconductor layer 15 is formed on the i-type semiconductor layer 14 by the plasma CVD apparatus. The n-type semiconductor layer 15 and the i-type semiconductor layer 14 are patterned, forming two-layer units having the size of the thin-film transistor 12. It should be noted that the temperature at which to form the gate insulating film 13 (i.e., an SiN film) is about 350°C in most cases, but the film 13 can have a sufficiently high withstand voltage if formed slowly at a relatively low temperature of about 250°C, at a low RF discharging power density.

Thereafter, the upper metal layer is formed by means of the sputtering apparatus. The upper metal layer is patterned, forming the source electrodes 16, the data liens 17, and drain electrodes 17a. Those portions of the n-type semiconductor layer 15, each exposed through the gap between the source electrode 16 and the drain electrode 17a, are etched away, thereby exposing the i-type semiconductor layer 14. As a result, the thin-film transistors 12 are fabricated.

Next, a transparent conductive layer, such as an ITO layer, is formed on the entire surface of the unfinished product, by means of the sputtering apparatus. This conductive layer is patterned, forming the pixel electrodes 18. Thus manufactured is the TFT panel.

The scan lines 11 of the TFT panel and the gate electrodes 11a formed integral with the scan lines 11 will now be described in greater detail.

The scan lines 11 and the gate electrodes 11a should better be made of aluminum which is an inexpensive metal having a low electrical resistivity. If the scan lines 11 and the gate electrodes 11a are made of pure aluminum, however, they will have hillocks on their surfaces when the gate insulating film 13, the i-type semiconductor layer 14, and/or the n-type semiconductor layer 15 is formed. If they are made of an aluminum alloy containing a high-melting metal such as Ti, they will have no hillocks but will have projections 6, as is shown in Figs. 6 and 7, when the gate insulating film 13, the i-type semiconductor layer 14, and/or the n-type semiconductor layer 15 is formed.

In this invention, the scan lines 11 and the gate electrodes 11a are made of aluminum containing a high-melting metal and oxygen and/or nitrogen, which will hereinafter be referred to as "Ti, oxygen/nitrogen-containing Aℓ."

The content of Ti in the Ti, oxygen/nitrogen-containing Aℓ is of such a value that the scan lines 11 and the gate electrodes 11a will have no hillocks when the gate insulating film 13, the semiconductor layer 14, and/or the semiconductor layer 15 is formed.

As indicated above, the gate insulating film 13 can be formed at a film-forming temperature of about 350°C or at a relatively low film-forming temperature of about 250°C. The i-type semiconductor layer 14 and the n-type semiconductor layer 15 are formed at about 250°C, and the upper metal layer and the pixel electrodes 18 are formed at about 100°C.

The highest of these temperatures is about 350°C at which the gate insulating film 13 is formed. Another point to consider is that the film 13 can be formed at about 250°C. Thus, if the film 13 is formed at about 350°C, it suffices to set the Ti content of the Ti, oxygen/nitrogen-containing Aℓ at such a value that the scan lines 11 and the gate electrodes 11a will have no hillocks when heated to about 350°C. Alternatively, if the film 13 is formed at about 250°C, it suffices to set the Ti content of the Ti, oxygen/nitrogen-containing Aℓ at such a value that the scan lines 11 and the gate electrodes 11a will have no hillocks when heated to about 250°C.

More specifically, it suffices to set the Ti content at 4.2 wt% or more if the gate insulating film 13 is formed at about 350°C, and at 2.2 wt% or more if the gate insulating film 13 is formed at about 250°C. If the scan lines 11 and the gate electrodes 11a are made of aluminum having such a Ti content, they will have no hillocks on their surfaces during the manufacture of the TFT panel.

It is difficult to control the Ti content accurately. In view of this, it would be desirable that the Ti content be a little greater than the value specified above (i.e., 4.2 wt% or 2.2 wt%). If the Ti content is too great, however, the lines 11 and the electrodes 11a will have excessively high resistances.

Hence, in the present invention, the Ti content of the Ti, oxygen/nitrogen-containing Aℓ is set at about 7 wt% if the gate insulating film 13 is formed at about 350°C, and at about 5 wt% if the film 13 is formed at about 250°C.

The oxygen and/or nitrogen content of the Ti, oxygen/nitrogen-containing Aℓ is set at about 4 at% or more, no matter whether the gate insulating film 13 is formed at about 350°C or about 250°C. If the oxygen and/or nitrogen content is less than about 4 at%, the scan lines 11 and the gate electrodes 11a will have such projections as are shown in Figs. 6 and 7, when the gate insulating film 13, the semiconductor layer 14, or the semiconductor layer 15 is formed. If the oxygen and/or nitrogen content is too high, for example, exceeding about 10 at%, the Ti, oxygen and/or nitrogen-containing Aℓ will likely become similar to an oxide or a nitride and will have an excessively high resistivity.

The layer of the Ti, oxygen/nitrogen-containing Aℓ (i.e., the lower conductive layer) can be formed by a sputtering apparatus, using a target made of aluminum containing a proper amount of titanium and an appropriate amount of oxygen and/or nitrogen. The temperature at which to form the layer of the Ti, oxygen/nitrogen-containing Aℓ is approximately 100°C.

The scan lines 11 and the gate electrodes 11a integral with the lines 11 of the TFT panel, which have been formed by patterning the lower conductive layer, are made of the Ti, oxygen/nitrogen-containing Aℓ having a Ti content of about 7 wt% or about 5 wt% and an oxygen and/or nitrogen content of about 4 at% or more. Hence, the scan lines 11 and the gate electrodes 11a will have no hillocks or projections when they are heated while the gate insulating film 13, the i-type semiconductor layer 14, or the n-type semiconductor layer 15 is being formed, as was probed by the results of the following experiment the inventors conducted.

In the experiment, a plurality of electrodes made of various Ti, oxygen/nitrogen-containing Aℓ having the same Ti content of about 5 wt% and different oxygen and/or nitrogen contents of 2.4 at%, 4.0 at% and 4.6 at% was formed on a glass substrate. The substrate was heated to 250°C, and the surface conditions of the electrodes were examined. The electrodes made of the Ti, oxygen/nitrogen-containing Aℓ having an oxygen and/or nitrogen content of 2.4 at% had no hillocks but had projections extending from the sides or edges. In contrast, the electrodes made of the Ti, oxygen/nitrogen-containing Aℓ having an oxygen and/or nitrogen contents of 4.0 at% and 4.6 at% had neither hillocks nor projections; they had smooth surfaces.

Since neither hillocks nor projections are formed on the scan lines 11 or the gate electrodes 11a during the forming of the gate insulating film 13 or the like, the gate insulating film 13 has no defects. Hence, the scan lines 11 (i.e., the lower conductive layers) are not short-circuited to the data lines 17 (i.e., the upper conductive layers), and gate electrodes 11a are not short-circuited to the source electrodes 16 or the drain electrodes 17a.

The data lines 17, the drain electrodes 17a, and the source electrodes 16, all incorporated in the TFT panel, can be made of metal such as aluminum containing only Ti or Ta. Nonetheless, they should better be made of the Ti, oxygen/nitrogen-containing Aℓ specified above. If they are made of this specific material, they will have neither hillocks nor projections when a protective insulating film (not shown) of SiN or the like is formed, and no defects such as cracks will be formed in the protective insulating film. Further, if the drain electrodes 17a and the source electrodes 16 are made of the Ti, oxygen/nitrogen-containing Aℓ, they will have their surfaces not roughened at all, and thus remain in firm bonding with the n-type semiconductor layer 15. As a result, the ohmic contact between the electrodes 16 and 17a, on the one hand, and the n-type semiconductor layer 15, on the other, is secured.

In the embodiment described above, Ti is used as high-melting metal to be contained in aluminum. Ti can be replaced by Ta or the like. Further, the aluminum may contain hydrogen as well. The gate insulating film 13 made of SiN can be replaced by a two-layer film consisting of a SiN film and an oxide film (e.g., a silicon oxide film, a tantalum oxide film, an aluminum oxide film, or the like).

Moreover, the reverse stagger thin-film transistors 12, used as active elements, can be replaced by reverse coplanar thin-film transistors, stagger thin-film transistors or coplanar thin-film transistors, or by thin-film diodes. If the active elements 12 are stagger thin-film transistors or coplanar thin-film transistors, the data lines 17 will be upper conductive layers, and the scan lines 11 will be lower conductive layers.

The TFT panel described above is designed for use in TFT active matrix liquid-crystal displays. Needless to say, the present invention can apply to any multi-layer wiring board that is similar to the TFT panel and that comprises thin-film devices.

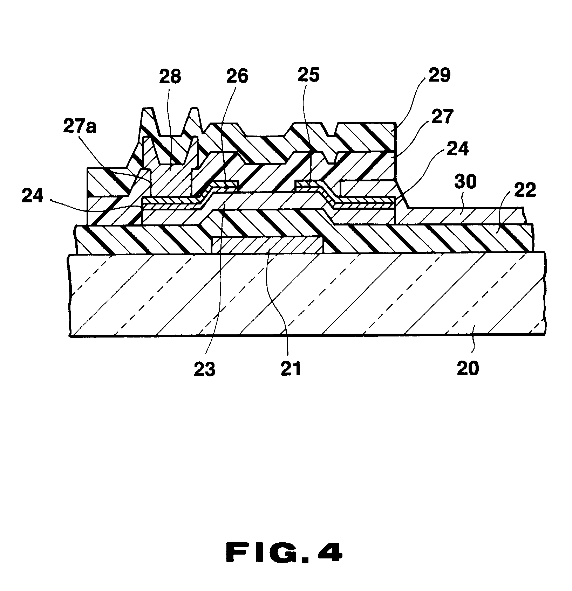

A second embodiment of the invention, i.e., a thin-film transistor different in structure from the transistors 12, will now be described with reference to Fig. 4.

As is evident from Fig. 4, this thin-film transistor comprises a gate electrode 21 formed on a substrate 10, a gate insulating film 22 made of SiN and formed on the substrate 20 and the gate electrode 21, an i-type semiconductor layer 23 made of a-Si, formed on the gate insulating film 22 and located above the gate electrode 21, an n-type semiconductor layer 24 made of a-Si doped with n-type impurity and formed on the i-type semiconductor layer 23, and a source electrode 25 and a drain electrode 26, both formed on the n-type semiconductor layer 24 and located above the opposing end portions of the i-type semiconductor layer 23.

The gate electrode 21 is integral with a scan line (not shown). The scan line is formed on the substrate 20, covered with the gate insulating film 22.

The gate insulating film 22 covers the entire surface of the substrate 20, but the scan line integral with the gate electrode 21. A pixel electrode 30 made of transparent conductive material such as ITO is formed on the gate insulating film 22 which is also transparent. The pixel electrode 30 has its one end portion overlapping the source electrode 25, and is therefore electrically connected to the source electrode 25.

The thin-film transistor is covered with an interlayer insulating film 27 made of SiN. A data line 28 is formed on the interlayer insulating film 27 and in the contact hole 27a made in the film 27. Hence, the data line 28 is connected to the drain electrode 26. A protective insulating film 29 made of SiN is formed on the thin-film transistor and the data line 28.

The thin-film transistor is manufactured by the following method.

First, a metal layer is formed on the substrate 20 by means of a sputtering apparatus. The metal layer is patterned, forming the gate electrodes 21 and also the scan lines integral with the electrodes 21. Next, the gate insulating film 22 is formed on the substrate 20, the scan lines, and the gate electrodes 21, by means of a plasma CVD apparatus. The i-type semiconductor layer 23 is formed on the gate insulating film 22, also by the plasma CVD apparatus. Then, the n-type semiconductor layer 24 is formed on the i-type semiconductor layer 23 by the plasma CVD apparatus. The n-type semiconductor layer 24 and the i-type semiconductor layer 23 are patterned, forming two-layerunits having the size of the thin-film transistor. It should be noted that the temperature at which to form the gate insulating film 22 (i.e., an SiN film) is about 350°C in most cases, but the film 22 can have a sufficiently high withstand voltage if formed slowly at a relatively low temperature of about 250°C, at a low RF discharging power density.

Thereafter, another metal layer is formed by means of the sputtering apparatus. This metal layer is patterned, forming the source electrodes 25, the drain electrodes 26, and the data lines integral with the electrodes 26. That portion of the n-type semiconductor layer 24 which is exposed through the gap between the source electrode 25 and the drain electrode 26, is etched away, thereby exposing the i-type semiconductor layer 24. As a result, the thin-film transistor is fabricated. Both the source electrode 25 and the drain electrode 26 are made of metal, such as Cr., which can readily form an ohmic contact with the n-type semiconductor layer 24.

Next, a transparent conductive layer, such as an ITO layer, is formed on the entire surface of the thin-film transistor by means of the sputtering apparatus. This conductive layer is patterned, forming the pixel electrodes 30. An SiN film is formed by the plasma CVD apparatus, and is subsequently pattern, forming the interlayer insulting film 27. Further, a metal layer is formed on the interlayer insulating film 27, by the sputtering apparatus, and is patterned, forming the data lines 28. Next, an SiN film is formed by the plasma CVD apparatus, and is subsequently pattern, forming the protective insulating film 29.

As in the first embodiment, the gate electrode 21 is made of aluminum containing a high-melting metal and oxygen and/or nitrogen. More specifically, the gate electrode 21 is made of aluminum containing titanium (Ti) and oxygen and/or nitrogen, or Ti, oxygen/nitrogen-containing Aℓ.

The content of Ti in the Ti, oxygen/nitrogen-containing Aℓ is of such a value that the gate electrode 21 and the scan line integral therewith will have no hillocks when the insulating films 22, 27 or 29, or the semiconductor layer 24 is formed.

As indicated above, the gate insulating film 22 can be formed at a film-forming temperature of about 350°C or at a relatively low film-forming temperature of about 250°C. The same holds true of the interlayer insulating film 27. The i-type semiconductor layer 23 and the n-type semiconductor layer 24 are formed at about 250°C, and the metal layers for forming the source and drain electrodes, the data line, and the pixel electrode are formed at about 100°C.

The highest of these temperatures is about 350°C at which the insulating films 22, 27, and 29 are formed. These films 22, 27, and 29 can formed formed at a lower temperature of about 250°C. Thus, if the films 22, 27, and 19 are formed at about 350°C, it suffices to set the Ti content of the Ti, oxygen/nitrogen-containing Aℓ at such a value that the gate electrode 21 and the scan line will have no hillocks when heated to about 350°C. Alternatively, if the insulating films 22, 27, and 29 are formed at about 250°C, it suffices to set the Ti content of the Ti, oxygen/nitrogen-containing Aℓ at such a value that the gate electrode 21 and the scan line will have no hillocks when heated to about 250°C.

The layer of Ti, oxygen/nitrogen-containing Aℓ (i.e., the layer of which to form the gate electrode) can be formed by a sputtering apparatus, using a target made of aluminum containing a proper amount of titanium and an appropriate amount of oxygen and/or nitrogen. Aℓternatively, the layer can be formed by means of sputtering in sputtering gas which contains oxygen and/or nitrogen. The temperature at which to form the layer of the Ti, oxygen/nitrogen-containing Aℓ is approximately 100°C.

The gate electrode 21, i.e., the lower conductive layer, of the thin-film transistor is made of the Ti, oxygen/nitrogen-containing Aℓ having a Ti content of about 7 wt% or about 5 wt% and an oxygen and/or nitrogen content of about 4 at% or more. Hence, the gate electrode 21 and the scan line integral with the electrode 21 will have no hillocks or projections, like the gate electrodes and the scan lines of the first embodiment, when they are heated while the gate insulating film 22, the i-type semiconductor layer 23, or the n-type semiconductor layer 24 is being formed.

In the thin-film transistor of Fig. 4, the source electrode 25 and the drain electrode 26, both formed of the upper layer, are made of metal such as chromium. Instead, these electrodes can be made of the Ti, oxygen/nitrogen-containing Aℓ specified above. If they are made of this specific material, they will not have their surfaces roughened at all when the interlayer insulating film 27 or the protective insulating film 29 is formed. Hence, the source electrode 25 and the drain electrode 26 remain in firm bonding with the n-type semiconductor layer 24. As a result, the ohmic contact between the electrodes 25 and 26, on the one hand, and the n-type semiconductor layer 24, on the other, is secured.

The data line 28 may be made of any metal desirable. Nonetheless, they should better be made of the Ti, oxygen/nitrogen-containing Aℓ specified above. If the data line 28 is made of this specific material, they will have neither hillocks nor projections when the protective insulating film 29 is formed on the data line 28, and no defects such as cracks will be formed in the protective insulating film 29. Even if the film 28 has defects, however, no great problems will arise. In view of this, the protective insulating film 29 can be made of aluminum or aluminum containing only Ti.

In the second embodiment (Fig. 4), Ti is used as high-melting metal to be contained in aluminum. Ti can be replaced by Ta or the like. Further, the aluminum may contain hydrogen as well. The gate insulating film 22 made of SiN can be replaced by a two-layer film consisting of a SiN film and an oxide film (e.g., a silicon oxide film, a tantalum oxide film, an aluminum oxide film, or the like).

The thin-film transistor shown in Fig. 4 is of reverse stagger type. Nonetheless, the present invention can be applied not only to a reverse stagger thin-film transistor, but also to a reverse coplanar thin-film transistor, a stagger thin-film transistor, a coplanar thin-film transistors, and a thin-film diode.

Electrodes made of aluminum containing high-melting metal such as Ti or Ta and oxygen and/or nitrogen can be formed by the following method.

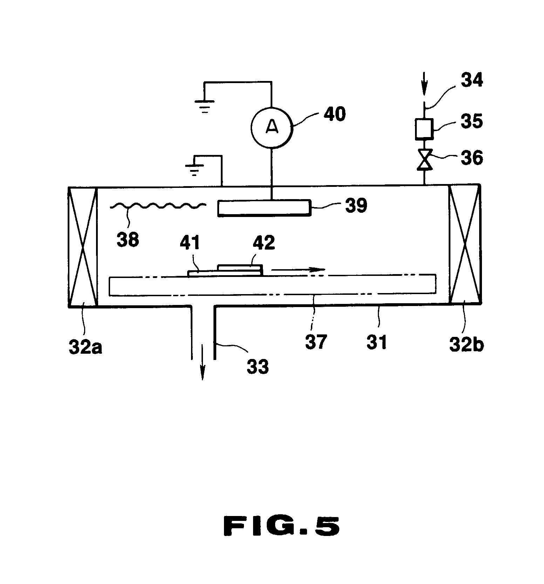

Fig. 5 shows a sputtering apparatus designed to form various metal layers. This apparatus comprises a sputtering chamber 31 having an inlet port and an outlet port through which to place a substrate within the chamber 31 and remove the same therefrom. It further comprises two airtight doors 32a and 32b for closing and opening the inlet port and the outlet port, respectively, an exhaust pipe 33 connecting the sputtering chamber 31 and a vacuum pump (not shown) located outside the chamber 31, and a sputtering gas pipe 34 connected to the chamber 31 for supplying a sputtering gas such as Ar gas into the sputtering chamber 31. A flow rate controller 35 and a valve 36 are arranged on the sputtering gas pipe 34. The sputtering chamber 31 contains a substrate-transporting mechanism 37, a heater 38, and a target 39. The mechanism 37 is mounted on the bottom of the chamber 31, for transporting a substrate from the inlet port to the outlet port. The heater 38 and the target 39 are located side by side, above the mechanism 37. The target 39 is connected to a sputtering power supply 40 which is positioned outside the chamber 31.

In this sputtering apparatus, a layer of aluminum alloy is formed on a substrate 41 in the following way, by using the target 39 which is made of the aluminum alloy containing high-melting metal such as Ti or Ta.

First, the airtight door 32a is opened, and the substrate 41 is inserted into the sputtering chamber 31 through the inlet port and placed on the substrate-transporting mechanism 27, with that surface turned upward on which to form an aluminum alloy layer.

Then, the airtight door 32a is closed, sealing the chamber 31 in airtight fashion. The vacuum pump (not shown) is driven, exhausting air from the chamber 31 until the pressure in the chamber 31 is reduced to 5 × 10⁻⁵ to 5 × 10⁻⁴ Torr. The reduced pressure is ten or more times to hundred or more times higher than the intra-chamber pressure (5 × 10⁻⁶ Torr or less) under which to form a layer by the conventional method. The chamber 31 is not completely void of air; a small amount of air remains in the sputtering chamber 31.

Thereafter, the heater 38 is turned on, heating the substrate 41, and the sputtering gas is introduced into the chamber 31. The substrate 41 is heated to a predetermined film-forming temperature, and the pressure of the sputtering gas is stabilized at a predetermined value (3 × 10⁻³ to 8 × 10⁻³ Torr). The mechanism 37 is driven, starting to move the substrate 41. Simultaneously, a discharge current is supplied from the sputtering power supply 40 to the target 39, whereby the sputtering is initiated. As is known in the art, the sputtering proceeds as will be described below.

When the discharge current is supplied to the target 39 from the power supply 40, plasma is generated. Particles of the aluminum alloy are thereby sputtered from the target 29 onto the substrate 41, whereby a layer of the aluminum alloy is deposited on the surface of the substrate 41.

In this method, the pressure in the chamber 31 is reduced to 5 × 10⁻⁵ to no less than 5 × 10⁻⁴ Torr after the substrate 41 has been placed within the chamber 31, and a small amount of air therefore remains in the sputtering chamber 31. The nitrogen, oxygen and hydrogen, contained in the air, are deposited on the substrate 41, along with the particles of the aluminum alloy. As a result, the aluminum alloy layer formed on the substrate 41 contains a small amount of nitrogen, oxygen and hydrogen.

Containing nitrogen, oxygen and hydrogen, the aluminum alloy layer formed by the method of the invention will have neither hillocks nor projections extending from its sides or edges as is shown in Figs. 6 and 7, even if it is heated to hundreds of degrees centigrade.

As has been described, in the thin-film device according to the invention which has a multi-layer structure specified above, the lower conductive layer is made of aluminum alloy, formed by the method descried above, and has neither hillocks nor projections which might otherwise be formed due to abnormal crystal growth.

## Claims

1. A thin-film device comprising an insulating substrate (10; 20), a first conductive layer (11; 21) located above the insulating substrate, an insulating film (13; 22) covering the first conductive layer; and a second conductive layer (16, 17a; 25, 26) formed on the insulating film and electrically insulated from the first conductive layer,
wherein said first conductive layer (11, 21) located close to said insulating substrate is made of aluminium alloy containing high-melting metal,
**characterised in that**
said first conductive layer (11; 21) contains 2.2 wt% or more of high-melting metal and 4 at% or more of oxygen or nitrogen, or both.

2. The thin-film device according to claim 1,
**characterised in that**
said high-melting metal consists of at least one selected from the group consisting of titanium and tantalum

3. The thin-film device according to claim 1 or 2
**characterised in that**
it forms a thin-film transistor comprising:
a gate electrode (11; 21) formed of said first conductive layer;
a gate insulating film (13; 22) formed of said insulating film, and covering said gate electrode and said insulating substrate;
an i-type semiconductor layer (14;23) formed on said gate insulating film; and
a source electrode (16; 25) and a drain electrode (17a, 26), both formed of said second conductive layer and electrically connected to two ends of said i-type semiconductor layer, respectively.

4. A thin-film device comprising:
an insulating substrate (20);
a plurality of transparent pixel electrodes (30) arranged in rows and columns on said insulating substrate;
a plurality of thin-film transistors located at said pixel electrodes, respectively, each having a gate electrode (21), a gate insulating film (22) formed on the gate electrode, an i-type semiconductor layer (23) formed on the gate insulating film, and a source electrode (25) and a drain electrode (26) electrically connected to two ends of the i-type semiconductor layer, respectively, and each having one of the source and drain electrodes connected to the associated pixel electrodes;
a plurality of scan lines extending parallel to one another, each connecting the gate electrodes of the thin film transistors of the same row; and
a plurality of data lines (28) extending parallel to one another, each connecting the source electrodes or drain electrodes of the thin-film transistors of the same column, which are other than those connected to the pixel electrodes,
wherein at least one of said gate electrodes, said source electrode, said drain electrode, said scan lines, and said data lines is constructed by a conductive layer made of aluminium alloy containing high-melting metal,
**characterised in that**
said conductive layer contains 2.2 wt% or more of high-melting metal and 4 at% or more of oxygen or nitrogen or both.

5. The thin-film device according to claim 4,
**characterised in that**
the gate electrode of each of said transistors is made of aluminium alloy, which contains at least one selected from the group consisting of titanium and tantalum, and about 4 at% or more of nitrogen or oxygen.

6. The thin film device according to claim 4,
**characterised in that**
said scan lines are made of aluminium alloy containing high-melting metal and oxygen or nitrogen or both.

7. The thin-film device according to claim 4,
**characterised in that**
said conductive layer contains 7 wt% or less of high-melting metal.

8. The thin-film device according to claim 7,
**characterised in that**
said conducting layer contains at least one high-melting metal selected from the group consisting of titanium and tantalum.

## Patentansprüche

1. Eine Dünnfilmanordnung, umfassend ein isolierendes Substrat (10; 20), eine erste leitende Schicht (11; 21), die über dem isolierenden Substrat lokalisiert ist, einen isolierenden Film (13; 22), der die erste leitende Schicht bedeckt; und eine zweite leitende Schicht (16, 17a; 25, 26), die auf dem isolierenden Film gebildet ist und von der ersten leitenden Schicht elektrisch isoliert ist,
wobei die erste leitende Schicht (11, 21), die in der Nähe des isolierenden Substrats lokalisiert ist, aus einer Aluminiumlegierung besteht, die ein hochschmelzendes Metall umfaßt,
**dadurch gekennzeichnet**, daß
die erste leitende Schicht (11; 21) 2,2 Gew.-% oder mehr des hochschmelzenden Metalls und 4 Atm.-% oder mehr Sauerstoff oder Stickstoff oder beides enthält.

2. Die Dünnfilmanordnung nach Anspruch 1,
**dadurch gekennzeichnet**, daß
das hochschmelzende Metall wenigstens ein Element enthält, das aus der Gruppe, die Titan und Tantal umfaßt, ausgewählt ist.

3. Die Dünnfilmanordnung nach Anspruch 1 oder 2,
**dadurch gekennzeichnet**, daß
sie einen Dünnfilmtransistor bildet, umfassend:
eine Gateelektrode (11; 21), die aus der ersten leitenden Schicht gebildet ist;
einen Gateisolationsfilm (13; 22), der aus dem isolierenden Film gebildet ist und die Gateelektrode und das isolierende Substrat bedeckt;
eine Halbleiterschicht vom i-Typ (14; 23), die auf dem Gateisolationsfilm gebildet ist; und
eine Sourceelektrode (16; 25) und eine Drainelektrode (17a, 26), die beide aus der zweiten leitenden Schicht gebildet sind und elektrisch entsprechend mit zwei Enden der Halbleiterschicht vom i-Typ verbunden sind.

4. Eine Dünnfilmanordnung, umfassend:
ein isolierendes Substrat (20);
eine Mehrzahl von transparenten Pixelelektroden (30), die auf dem isolierenden Substrat in Reihen und Spalten angeordnet sind;
eine Mehrzahl von Dünnfilmtransistoren, die entsprechend an den Pixelelektroden lokalisiert sind, von denen jeder eine Gateelektrode (21), einen Gateisolationsfilm (22), der auf der Gateelektrode ausgebildet ist, eine Halbleiterschicht vom i-Typ (23), die auf den Gateisolationsfilm gebildet ist, und eine Sourceelektrode (25) und eine Drainelektrode (26), die elektrisch entsprechend mit zwei Enden der Halbleiterschicht vom i-Typ verbunden sind, aufweist, und wobei entweder die Source-oder die Drainelektrode eines jeden mit den assoziierten Pixelelektroden verbunden ist;
eine Mehrzahl von Abtastleitungen, die sich parallel zueinander erstrecken, wobei jede die Gateelektroden des Dünnfilmtransistors derselben Reihe verbindet; und
eine Mehrzahl von Datenleitungen (28), die sich parallel zueinander erstrecken, wobei jede die Sourceelektroden oder Drainelektroden der Dünnfilmtransistoren derselben Spalte, die sich von denen unterscheiden, die mit den Pixelelektroden verbunden sind, verbinden,
wobei wenigstens ein Element aus der Gruppe, die die Gateelektroden, die Sourceelektrode, die Drainelektrode, die Abtastleitungen und die Datenleitungen umfaßt, aus einer leitenden Schicht aufgebaut ist, die aus einer Aluminiumlegierung besteht, die hochschmelzendes Metall umfaßt,
**dadurch gekennzeichnet**, daß
die leitende Schicht 2,2 Gew.-% oder mehr des hochschmelzenden Metalls und 4 Atm.-% oder mehr an Sauerstoff oder Stickstoff oder beidem enthält.

5. Die Dünnfilmanordnung nach Anspruch 4,
**dadurch gekennzeichnet**, daß
die Gateelektrode eines jeden Transistors aus einer Aluminiumlegierung besteht, die wenigstens ein Element enthält, das aus der Gruppe, die Titan und Tantal umfaßt, ausgewählt ist, und ungefähr 4 Atm.-% oder mehr an Stickstoff oder Sauerstoff umfaßt.

6. Die Dünnfilmanordnung nach Anspruch 4,
**dadurch gekennzeichnet**, daß
die Abtastleitungen aus einer Aluminiumlegierung bestehen, die hochschmelzendes Metall und Sauerstoff und Stickstoff oder beides umfaßt.

7. Die Dünnfilmanordnung nach Anspruch 4,
**dadurch gekennzeichnet**, daß
die leitende Schicht 7 Gew.-% oder weniger des hochschmelzenden Metalls enthält.

8. Die Dünnfilmanordnung nach Anspruch 7,
**dadurch gekennzeichnet**, daß
die leitende Schicht wenigstens ein hochschmelzendes Metall enthält, das aus der Gruppe, die Titan und Tantal umfaßt, ausgewählt ist.

## Revendications

1. Dispositif en film mince comprenant un substrat isolant (10; 20), une première couche conductrice (11; 21) située au-dessus du substrat isolant, un film isolant (13; 22) recouvrant la première couche conductrice; et une seconde couche conductrice (16, 17a; 25, 26) formée sur le film isolant et manifestant une isolation électrique par rapport à la première couche conductrice,
dans lequel ladite première couche conductrice (11; 21) située à proximité dudit substrat isolant est réalisée en un alliage d'aluminium contenant un métal possédant un point de fusion élevé,
caractérisé en ce que
ladite première couche conductrice (11; 21) contient 2,2% en poids ou plus d'un métal à point de fusion élevé et 4% en atm ou plus d'oxygène ou d'azote ou des deux.

2. Dispositif en film mince selon la revendication 1,
caractérisé en ce que
ledit métal à point de fusion élevé est constitué d'au moins un métal choisi parmi le groupe constitué par le titane et le tantale.

3. Dispositif en film mince selon la revendication 1 ou 2,
caractérisé en ce que
il forme un transistor à film mince comprenant:
une électrode de grille (11; 21) formée par ladite première couche conductrice;
un film isolant de grille (13; 22) formé par ledit film isolant et recouvrant ladite électrode de grille et ledit substrat isolant;
une couche semi-conductrice type I (14; 23) formée sur ledit film isolant de grille; et
une électrode de source (16; 25) et une électrode de drain (17a, 26), toutes deux formées par ladite seconde couche conductrice et reliées électriquement aux deux extrémités de ladite couche semi-conductrice de type I, respectivement.

4. Dispositif en film mince comprenant:
un substrat isolant (20);
plusieurs électrodes transparentes à pixels (30) arrangées en rangs et en colonnes sur ledit substrat isolant;
plusieurs transistors en film mince positionnés auxdites électrodes à pixels, respectivement, chacun possédant une électrode de grille (21), un film isolant de grille (22) formé sur l'électrode de grille, une couche semi-conductrice de type I (23) formée sur le film isolant de grille et une électrode de source (25) et une électrode de drain (26) reliées électriquement aux deux extrémités de la couche semi-conductrice de type I, respectivement, l'électrode de source et l'électrode de drain de chacun d'eux étant reliées aux électrodes à pixels associées;
plusieurs lignes de balayage s'étendant parallèlement l'une à l'autre, chacune reliant les électrodes de grille des transistors à film mince du même rang; et
plusieurs lignes de données (28) s'étendant parallèlement l'une à l'autre, chacune reliant les électrodes de source ou les électrodes de drain des transistors en film mince de la même colonne, qui sont différentes de celles reliées aux électrodes à pixels,
dans lequel au moins un élément parmi lesdites électrodes de grille, lesdites électrodes de source, lesdites électrodes de drain, lesdites lignes de balayage et lesdites lignes de données est formé par une couche conductrice réalisée en un alliage d'aluminium contenant un métal à point de fusion élevé,
caractérisé en ce que
ladite couche conductrice contient 2,2% en poids ou plus d'un métal à point de fusion élevé et 4% en atm ou plus d'oxygène ou d'azote ou des deux.

5. Dispositif en film mince selon la revendication 4,
caractérisé en ce que
l'électrode de grille de chacun desdits transistors est réalisée en un alliage d'aluminium qui contient au moins un élément choisi parmi le groupe constitué par le titane et le tantale, et environ 4% en atm ou plus d'azote ou d'oxygène.

6. Dispositif en film mince selon la revendication 4,
caractérisé en ce que
lesdites lignes de balayage sont réalisées en un alliage d'aluminium contenant un métal à point de fusion élevé et de l'oxygène ou de l'azote ou encore les deux.

7. Dispositif en film mince selon la revendication 4,
caractérisé en ce que
ladite couche conductrice contient 7% en poids ou moins d'un métal à point de fusion élevé.

8. Dispositif en film mince selon la revendication 7,
caractérisé en ce que
ladite couche conductrice contient au moins un métal à point de fusion élevé choisi parmi le groupe constitué par le titane et le tantale.
